(19) **Europäisches Patentamt**
**European Patent Office**
**Office européen des brevets**

(11) **EP 1 322 969 B1**

(12) **EUROPEAN PATENT SPECIFICATION**

(45) Date of publication and mention
of the grant of the patent:
**29.12.2004 Bulletin 2004/53**

(51) Int Cl.⁷: **G01R 21/10**

(86) International application number:
**PCT/GB2001/004378**

(21) Application number: **01972270.1**

(22) Date of filing: **02.10.2001**

(87) International publication number:
**WO 2002/029425 (11.04.2002 Gazette 2002/15)**

(54) **RF POWER MEASUREMENT**

RADIOFREQUENZLEISTUNGSMESSUNG

MESURE DE PUISSANCE RF

(84) Designated Contracting States:
**AT BE CH CY DE DK ES FI FR GB GR IE IT LI LU MC NL PT SE TR**

(30) Priority: **04.10.2000 GB 0024325**

(43) Date of publication of application:
**02.07.2003 Bulletin 2003/27**

(73) Proprietor: **Racal Instruments Wireless Solutions Limited**
**Slough, Berkshire SL1 6BE (GB)**

(72) Inventor: **HILTON, Oliver, James**
**31015 Conegliano (TV) (IT)**

(74) Representative: **Bibby, William Mark et al**
**Mathisen, Macara & Co.,**
**The Coach House,**
**6-8 Swakeleys Road**
**Ickenham Uxbridge UB10 8BZ (GB)**

(56) References cited:
**EP-A- 0 843 420      WO-A-98/44661**

EP 1 322 969 B1

## Description

This invention relates to the measurement of RF power, and the invention relates particularly to a RF power measurement circuit and method employing an over-sampling analogue-to-digital conversion (ADC) circuit. As known to those skilled in the art, an over-sampling ADC requires a finite number N of clock cycles (where N > 1) to complete a single conversion.

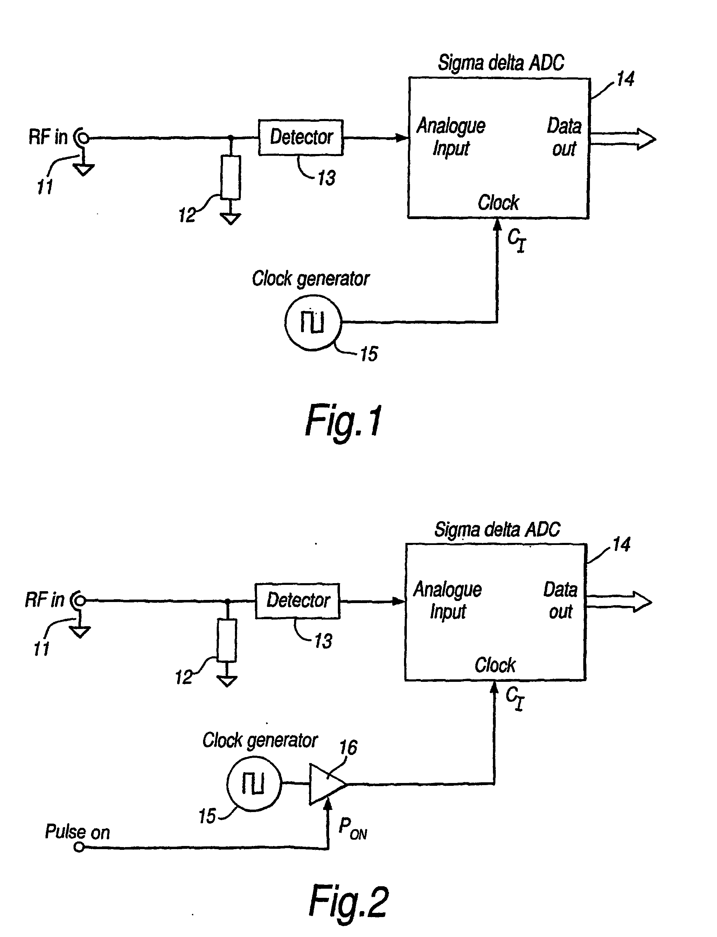

Figure 1 of the accompanying drawings is a block diagram showing a known RF power measurement circuit. It comprises a RF input 11, a load 12, a Schottky diode 13, an over-sampling ADC circuit in the form of a sigma-delta ADC circuit 14 and a clock generator 15.

In use, Schottky diode 13 functions as a detector which outputs voltage related to RF power reaching the RF input 11. The ADC circuit 14 converts this voltage to digital format giving a measure of RF power which can be stored for further processing.

The clock generator 15 supplies clock pulses to the clock input $C_I$ of the ADC circuit 14, and these pulses define the conversion rate of the ADC circuit. The conversion time $T_{CONV}$ of the ADC circuit is given by the expression:

$$T_{CONV} = \frac{N}{F_{CLOCK}},$$

where N is the number of clock pulses required to complete a single conversion and $F_{CLOCK}$ is the frequency of the clock generator 15. Hitherto, it has been customary to use a high speed ADC circuit having a conversion time $T_{CONV}$ which is much shorter than the RF pulse length, and so several power measurements can be derived from each RF pulse. Generally, a sigma-delta ADC circuit has been preferred since high ADC resolution can be realised at lower cost than other conversion techniques.

WO-9844661A and EP-A-0843420 describe other examples of known power measurement circuits.

It would be desirable to use a low speed over-sampling ADC circuit which is significantly cheaper than a high speed over-sampling ADC circuit and yet is still capable of achieving high ADC resolution leading to improved measurement accuracy. However, a low speed over-sampling ADC circuit presents a significant technical problem when the conversion time of the ADC circuit is longer that the RF pulse length.

According to one aspect of the invention there is provided a RF power measurement circuit for measuring RF power of a pulsed RF input signal comprising detector means for converting said input signal to voltage, over-sampling analogue-to-digital conversion means for deriving a measure of RF power from said voltage, clock generation means for generating clock pulses and means for controlling delivery of said clock pulses to a clock input of said over-sampling analogue-to-digital conversion means.

In a preferred implementation, said means for controlling causes said clock pulses to be delivered to said clock input only within the duration of RF pulses of the pulsed RF input signal and, preferably, after the start of respective RF pulses. Since, with this arrangement, clock signals are delivered to the clock input of the ADC only within the duration of the RF pulses, it is possible to derive a single power measurement from two or more successive RF pulses. Accordingly, this arrangement enables use of a low speed over-sampling ADC having a conversion time longer than the RF pulse length.

According to another aspect of the invention there is provided a method of measuring RF power of a pulsed RF signal comprising the steps of converting the pulsed RF signal to voltage, using over-sampling analogue-to-digital conversion means to derive a measure of RF power from said voltage and controlling delivery of clock pulses to a clock input of said over-sampling analogue-to-digital conversion means.

An embodiment of the invention is now described, by way of example only, with reference to the accompanying drawings of which:

Figure 1 is a block diagram showing a known RF power measurement circuit,

Figure 2 is a block diagram showing a RF power measurement circuit according to the invention, and

Figures 3(a) to 3(d) are timing diagrams useful in understanding operation of the RF power measurement circuit shown in Figure 2.

Referring to Figure 2, many of the circuit components are the same as those used in the circuit of Figure 1, and have been ascribed like reference numerals.

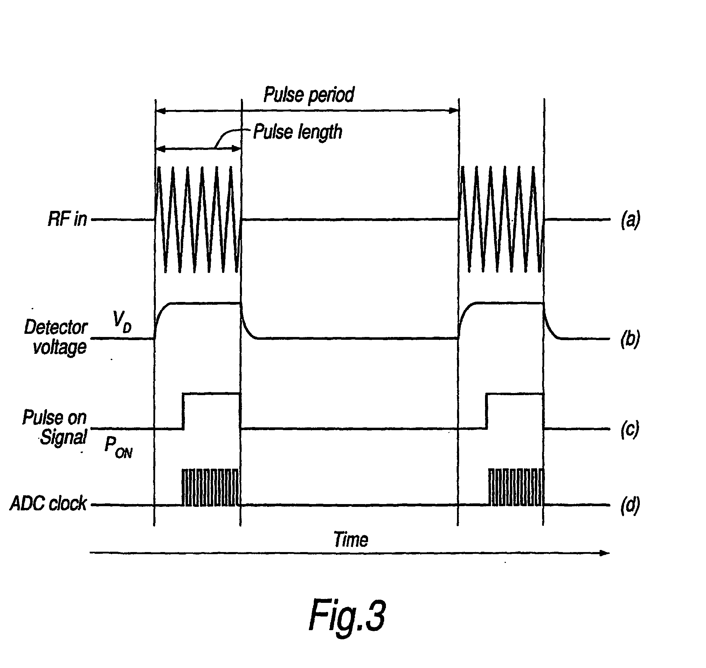

As in the case of the circuit shown in Figure 1, a RF input signal $R_{IN}$ (shown in Figure 3(a)) is received at the RF input 11, terminated by the load 12 and converted by Schottky diode 13 to voltage $V_D$ (shown in Figure 3(b)) related to RF power reaching the RF input 11. The sigma-delta ADC circuit 14 then converts the detected voltage $V_D$ to digital format and thereby generates data representing a measure of RF power at the converter output.

As before, the RF power measurement circuit 14 has a clock generator 15, but differs from the circuit of Figure 1 by provision of AND gate 16 connected between the clock generator 15 and the clock input $C_I$ of the ADC circuit 14. The AND gate 16 has an output terminal connected to the clock input, a first input terminal connected to the clock generator 15 and a second input terminal connected to receive an externally generated 'Pulse-on' signal $P_{ON}$ in the form of a pulse train (shown in Figure 3(c)). The AND gate 16 functions, in effect, as a switch enabling clock pulses to be delivered to the clock input $C_I$ of the ADC circuit 14 while the switch is closed (when $P_{ON}$ is "high") and preventing such delivery when the switch is open (when $P_{ON}$ is "low"). The timing of the 'Pulse-on' signal is related to the timing of the RF pulses of the RF input signal and its effect is to enable delivery of clock pulses to the clock input $C_I$ of the ADC circuit 14, but only within the duration of the RF pulses (as shown in Figure 3(d)). Thus, pulses will only be delivered to the clock input when a RF pulse is present.

As shown in Figure 3(b), Schottky diode 13 has a significant time constant causing the detection voltage $V_D$ to rise and fall exponentially in response to leading and trailing edges respectively of each RF pulse. To take account of this, each pulse of the 'Pulse-on' signal $P_{ON}$ is generated a short time after the start of the associated RF pulse thereby allowing the detector voltage sufficient time to settle before any clock pulses are delivered to the clock input of the ADC circuit. In practice, to enable accurate power measurements to be made, the detector time constant should be much shorter than the RF pulse length.

Since the clock signals are delivered to the clock input of the ADC circuit 14 only within the duration of the RF pulses, it is possible to derive a single power measurement from two or more successive RF pulses; accordingly, a low speed ADC circuit can be used, having a conversion time which is much longer than the RF pulse length.

Alternatively, a high speed ADC circuit could be used; in this case, the timing of the 'Pulse-on' signal $P_{ON}$ will eliminate power measurements that would otherwise be made while the detector voltage $V_D$ is rising or falling, thereby improving accuracy of the measurement.

It will be appreciated that although the RF power measurement circuit described with reference to Figure 2 includes a sigma-delta ADC circuit, other forms of over-sampling ADC circuit could alternatively be used.

Similarly, although an AND gate 16 and a Schottky diode 13 have been used other components capable of performing substantially the same switching and detection functions could alternatively be used e.g. a synchronous clock enabling circuit could be used for the switching function and a field effect transistor could be used for the detection function.

It will also be appreciated that RF power may be measured over any desired part of the input waveform, which need not necessarily include a RF pulse.

## Claims

1. A RF power measurement circuit for measuring RF power of a pulsed RF input signal comprising detector means (13) for converting said input signal to voltage, an over-sampling analogue-to-digital conversion means (14) for deriving a measure of RF power from said voltage, clock generation means (15) for generating clock pulses and means (16) for controlling delivery of said clock pulses to a clock input ($C_I$) of said over-sampling analogue-to-digital conversion means (14).

2. A measurement circuit as claimed in claim 1 wherein said means for controlling (16) is connected between said clock generation means (15) and said clock input ($C_I$) and is responsive to a control signal ($P_{ON}$) whose timing is related to the timing of RF pulses of the pulsed RF input signal.

3. A measurement circuit as claimed in claim 1 or claim 2 wherein said means for controlling (16) causes said clock pulses to be delivered to said clock input ($C_I$) only within the duration of RF pulses of the pulsed RF input signal.

4. A measurement circuit as claimed in claim 3 wherein said means for controlling (16) causes said clock pulses to be delivered to said clock input ($C_I$) after the start of respective said RF pulses.

5. A measurement circuit as claimed in claim 1 wherein said means for controlling (16) comprises switching means responsive to control pulses ($P_{ON}$).

6. A measurement circuit as claimed in claim 5 wherein the timing of said control pulses is related to the timing of RF pulses of said pulsed RF input signal.

7. A measurement circuit as claimed in claim 6 wherein the leading edge of each control pulse follows the start of a respective said RF pulse.

8. A measurement circuit as claimed in any one of claims 5 to 7 wherein said switching means is an AND gate.

9. A measurement circuit as claimed in any one of claims 1 to 8 wherein said detection means (13) is a Schottky diode.

10. A measurement circuit as claimed in any one of claims 1 to 9 wherein said over-sampling analogue-to-digital conversion circuit (14) is a sigma-delta analogue-to-digital conversion circuit.

11. A measurement circuit as claimed in any one of claims 1 to 10 wherein said over-sampling analogue-to-digital conversion circuit (14) has a conversion time longer than the RF pulse width.

12. A method of measuring RF power of a pulsed RF signal comprising the steps of converting the pulsed RF signal to voltage, using over-sampling analogue-to-digital conversion means (14) to derive a measure of RF power from said voltage and controlling delivery of clock pulses to a clock input ($C_I$) of said over-sampling analogue-to-digital conversion means (14).

13. A method as claimed in claim 12 wherein said controlling step causes said clock pulses to be supplied to said clock input ($C_I$) only within the duration of RF pulses of the pulsed RF signal.

14. A method as claimed in claim 13 wherein said controlling step causes said clock pulses to be delivered to said clock input ($C_I$) after the start of respective said RF pulses.

**Patentansprüche**

1. HF-Leistungsmessschaltung zum Messen von HF-Leistung eines gepulsten HF-Eingangssignals, die eine Detektoreinrichtung (13) zum Umwandeln des Eingangssignals in Spannung, eine Überabtast-A/D-Wandeleinrichtung (14) zum Herleiten eines Maßes von HF-Leistung aus der Spannung, eine Takterzeugungseinrichtung (15) zum Erzeugen von Taktimpulsen und eine Einrichtung (16) zum Steuern der Abgabe der Taktimpulse an einen Takteingang ($C_1$) der Überabtast-A/D-Wandeleinrichtung (14) umfasst.

2. Messschaltung nach Anspruch 1, wobei die Einrichtung zum Steuern (16) zwischen die Takterzeugungseinrichtung (15) und den Takteingang ($C_1$) geschaltet ist und auf ein Steuersignal ($P_{ON}$) anspricht, dessen Zeitablauf mit dem Zeitablauf von HF-Impulsen des gepulsten HF-Eingangssignals zusammenhängt.

3. Messschaltung nach Anspruch 1 oder Anspruch 2, wobei die Einrichtung zum Steuern (16) bewirkt, dass die Taktimpulse nur während der Dauer von HF-Impulsen des gepulsten HF-Eingangssignals an den Takteingang ($C_1$) abgegeben werden.

4. Messschaltung nach Anspruch 3, wobei die Einrichtung zum Steuern (16) bewirkt, dass die Taktimpulse nach dem Beginn der entsprechenden HF-Impulse an den Takteingang ($C_1$) abgegeben werden.

5. Messschaltung nach Anspruch 1, wobei die Einrichtung zum Steuern (16) eine Schalteinrichtung umfasst, die auf Steuerimpulse ($P_{ON}$) anspricht.

6. Messschaltung nach Anspruch 5, wobei der Zeitablauf der Steuerimpulse mit dem Zeitablauf von HF-Impulsen des gepulsten HF-Eingangssignals zusammenhängt.

7. Messschaltung nach Anspruch 6, wobei die Anstiegsflanke jedes Steuerimpulses auf den Beginn eines entsprechenden HF-Impulses folgt.

8. Messschaltung nach einem der Ansprüche 5 bis 7, wobei die Schalteinrichtung ein UND-Glied ist.

9. Messschaltung nach einem der Ansprüche 1 bis 8, wobei die Erfassungseinrichtung (13) eine Schottky-Diode ist.

10. Messschaltung nach einem der Ansprüche 1 bis 9, wobei die Überabtast-A/D-Wandelschaltung (14) eine Sigma-Delta-A/D-Wandelschaltung ist.

11. Messschaltung nach einem der Ansprüche 1 bis 10, wobei die Überabtast-A/D-Wandelschaltung (14) eine Wandelzeit hat, die länger ist als die HF-Impulsbreite.

12. Verfahren zum Messen von HF-Leistung eines gepulsten HF-Signals, das die Schritte des Umwandelns des gepulsten HF-Signals in Spannung, den Einsatz einer Überabtast-A/D-Wandeleinrichtung (14) zum Herleiten eines Maßes von HF-Leistung aus der Spannung und des Steuems der Abgabe von Taktimpulsen an einen Takteingang ($C_1$) der Überabtast-A/D-Wandeleinrichtung (14) umfasst.

13. Verfahren nach Anspruch 12, wobei der Steuerschritt bewirkt, dass die Taktimpulse nur innerhalb der Dauer von HF-Impulsen des gepulsten HF-Signals dem Takteingang ($C_1$) zugeführt werden.

14. Verfahren nach Anspruch 13, wobei der Steuerschritt bewirkt, dass die Taktimpulse nach dem Beginn der entsprechenden HF-Impulse an den Takteingang ($C_1$) abgegeben werden.

**Revendications**

1. Circuit de mesure de puissance de radiofréquence, dite puissance RF, servant à mesurer la puissance RF d'un signal d'entrée RF pulsé, comprenant un moyen détecteur (13) servant à convertir ledit signal d'entrée en tension, un moyen (14) de conversion analogique-numérique de suréchantillonnage servant à déduire une mesure de la puissance RF à partir de ladite tension, un moyen (15) générateur de signal d'horloge servant à produire des impulsions d'horloge, et un moyen (16) servant à commander la délivrance desdites impulsions d'horloge à une entrée d'horloge ($C_1$) dudit moyen (14) de conversion analogique-numérique de suréchantillonnage.

2. Circuit de mesure selon la revendication 1, où ledit moyen de commande (16) est connecté entre ledit moyen (15) générateur de signal d'horloge et ladite entrée d'horloge ($C_1$) et répond à un signal de commande ($P_{ON}$) dont le positionnement temporel est lié au positionnement temporel des impulsions RF du signal d'entrée RF pulsé.

3. Circuit de mesure selon la revendication 1 ou 2, où ledit moyen de commande (16) fait en sorte que lesdites impulsions d'horloge ne soient délivrées à ladite entrée d'horloge ($C_1$) que pendant la durée des impulsions RF du signal d'entrée RF pulsé.

4. Circuit de mesure selon la revendication 3, où ledit moyen de commande (16) fait en sorte que lesdites impulsions d'horloge soient délivrées à ladite entrée d'horloge ($C_1$) après le début desdites impulsions RF respectives.

5. Circuit de mesure selon la revendication 1, où ledit moyen de commande (16) comprend un moyen de commutation qui répond à des impulsions de commande ($P_{ON}$).

6. Circuit de mesure selon la revendication 5, où le positionnement temporel desdites impulsions de commande est lié au positionnement temporel des impulsions RF dudit signal d'entrée RF pulsé.

7. Circuit de mesure selon la revendication 6, où le flanc antérieur de chaque impulsion de commande suit le début d'une dite impulsion RF respective.

8. Circuit de mesure selon l'une quelconque des revendications 5 à 7, où ledit moyen de commutation est une porte ET.

9. Circuit de mesure selon l'une quelconque des revendications 1 à 8, où ledit moyen de détection (13) est une diode Schottky.

10. Circuit de mesure selon l'une quelconque des revendications 1 à 9, où ledit circuit de conversion analogique-numérique de suréchantillonnage (14) est un circuit de conversion analogique-numérique sigma-delta.

11. Circuit de mesure selon l'une quelconque des revendications 1 à 10, où ledit circuit de conversion analogique-numérique de suréchantillonnage (14) possède une durée de conversion qui est plus longue que la largeur d'impulsion RF.

12. Procédé de mesure de la puissance de radiofréquence, dite puissance RF, d'un signal RF pulsé, comprenant les opérations suivantes, à savoir convertir le signal RF pulsé en tension, utiliser un moyen de conversion analogique-numérique de suréchantillonnage (14) pour déduire une mesure de la puissance RF à partir de ladite tension et commander la délivrance d'impulsions d'horloge à une entrée d'horloge (C1) dudit moyen de conversion analogique-numérique de suréchantillonnage (14).

13. Procédé selon la revendication 12, où ladite opération de commande fait en sorte que lesdites impulsions d'horloge ne soient délivrées à ladite entrée d'horloge ($C_1$) que pendant la durée des impulsions RF du signal RF pulsé.

14. Procédé selon la revendication 13, où ladite opération de commande fait en sorte que lesdites impulsions d'horloge soient délivrées à ladite entrée d'horloge ($C_1$) après le début desdites impulsions RF respectives.

Sigma delta ADC

*14*

RF in ○

*11*

*12*

Detector

*13*

Analogue
Input

Data
out

Clock

$C_I$

Clock generator

*15*

## Fig.1

Sigma delta ADC

*14*

RF in ○

*11*

*12*

Detector

*13*

Analogue
Input

Data
out

Clock

$C_I$

Clock generator

*16*

*15*

Pulse on ○

$P_{ON}$

## Fig.2

Fig.3